# EUROPEAN PATENT SPECIFICATION

(11) **EP 2 475 013 B1**
(45) Date of publication and mention of the grant of the patent: **12.02.2020**
(21) Application number: 10820854.7
(22) Date of filing: 30.09.2010
(51) Int. Cl.: H01L 31/0749, H01L 31/046

(54) **SOLAR POWER GENERATION APPARATUS AND MANUFACTURING METHOD THEREOF**
VORRICHTUNG ZUR SOLARSTROMERZEUGUNG SOWIE VERFAHREN ZU IHRER HERSTELLUNG
APPAREIL DE GÉNÉRATION D'ÉNERGIE SOLAIRE ET SON PROCÉDÉ DE FABRICATION

(30) Priority: 30.09.2009 KR 20090093531
(43) Date of publication of application: 11.07.2012
(73) Proprietor: LG Innotek Co., Ltd., Seoul, 04637 (KR)
(72) Inventor: PAK, Hi Sun, Seoul 100-714 (KR)
(74) Representative: Novagraaf Technologies
(86) International application number: PCT/KR2010/006708
(87) International publication number: WO 2011/040781

(56) References cited:
- EP-A2- 0 427 934
- JP-A- S60 262 471
- JP-A- 2002 093 476
- JP-A- 2002 093 476
- KR-A- 20060 066 280
- KR-A- 20070 004 593
- US-A1- 2009 199 899

## Description

### [Technical Field]

The embodiment relates to a solar cell apparatus and a method for manufacturing the same.

### [Background Art]

Recently, as energy consumption is increased, the development on a solar cell to convert solar energy into electrical energy has been performed.

In particular, a CIGS-based solar cell has been extensively used, in which the CIGS-based solar cell is a PN hetero junction device having a substrate structure including a substrate, a metallic back electrode layer, a P type CIGS-based light absorbing layer, a high resistance buffer layer, and an N type window layer.

Recently, as energy consumption is increased, the development on a solar cell to convert solar energy into electrical energy has been performed.

In particular, a CIGS-based solar cell has been extensively used, in which the CIGS-based solar cell is a PN hetero junction device having a substrate structure including a substrate, a metallic back electrode layer, a P type CIGS-based light absorbing layer, a high resistance buffer layer, and an N type window layer.

The above layers constituting the solar cell are sequentially deposited on a substrate. The above layers are deposited at different degrees. Accordingly, electrical problems may be caused in a solar cell at an edge region.

To this regard, the edge region is patterned by using a laser when a solar cell is formed. In this case, a great amount of electrode residues may be produced due to the laser patterning.

The electrode residues cause the leakage current at the lateral side of the solar cell corresponding to the edge region, so that the electrical characteristic of the solar cell may be degraded.

Documents US 2009/199899 A1 and JP S60 262471 A disclose prior art solar cell apparatuses comprising a substrate including a cell region and an edge region surrounding the cell region, a back electrode layer on the substrate, a light absorbing layer on the back electrode layer and a front electrode layer on the light absorbing layer, wherein the outer lateral side of the back electrode layer is aligned on a plane different from a plane of the outer lateral side of the front electrode layer.

### [Disclosure]

### [Technical Problem]

The embodiment provides a solar cell apparatus and a method for manufacturing the same, capable of representing improved electrical characteristics by blocking leakage current at the edge region of a substrate.

### [Technical Solution]

According to the invention, there is provided a solar cell apparatus according to claim 1 and a method for manufacturing a solar cell apparatus according to claim 8.

### [Advantageous Effects]

According to the solar cell apparatus of the invention, outer lateral sides of the back electrode layer and the front electrode layer are provided on different planes. Therefore, the distance between the outer lateral sides of the back electrode layer and the front electrode layer can be increased.

Therefore, the outer lateral side of the back electrode layer can be prevented from being shorted with the outer lateral side of the front electrode layer. In addition, the leakage current between the outer lateral sides of the back electrode layer and the front electrode layer can be blocked.

In particular, the outer lateral side of the back electrode layer may be covered by the light absorbing layer including a semiconductor compound. Therefore, the outer lateral side of the back electrode layer can be effectively insulated.

According to the solar cell apparatus of the invention, the short and the leakage current of the back electrode layer and the front electrode layer can be prevented. Therefore, the solar cell apparatus can represent high photoelectric-transformation efficiency with the improved electrical characteristics.

### [Description of Drawings]

FIG. 1 is a plan view showing a solar cell apparatus according to an example of the disclosure;
FIG. 2 is a sectional view taken along line I-I' of FIG. 1;
FIG. 3 is a sectional view showing taken along II-II' of FIG. 1;
FIGS. 4 to 9 are sectional views showing a method for fabricating the solar cell apparatus according to the example;
FIG. 10 is a plan view showing a solar cell apparatus according to the invention;
FIG. 11 is a sectional view taken along line III-III' of FIG. 10;
FIG. 12 is a sectional view showing taken along line IV-IV' of FIG. 10; and
FIGS. 13 to 18 are sectional views showing a method for manufacturing a solar cell apparatus according to the invention.

### [Best Mode]

### [Mode for Invention]

In the description of the examples, it will be understood that, when a layer (or film), a region, a pattern, or a structure is referred to as being " on" or " under" another substrate, another layer (or film), another region, another pad, or another pattern, it can be " directly" or " indirectly" on the other substrate, layer (or film), region, pad, or pattern, or one or more intervening layers may also be present. Such a position of the layer has been described with reference to the drawings. The thickness and size of each layer shown in the drawings may be exaggerated, omitted or schematically drawn for the purpose of convenience or clarity. In addition, the size of elements does not utterly reflect an actual size.

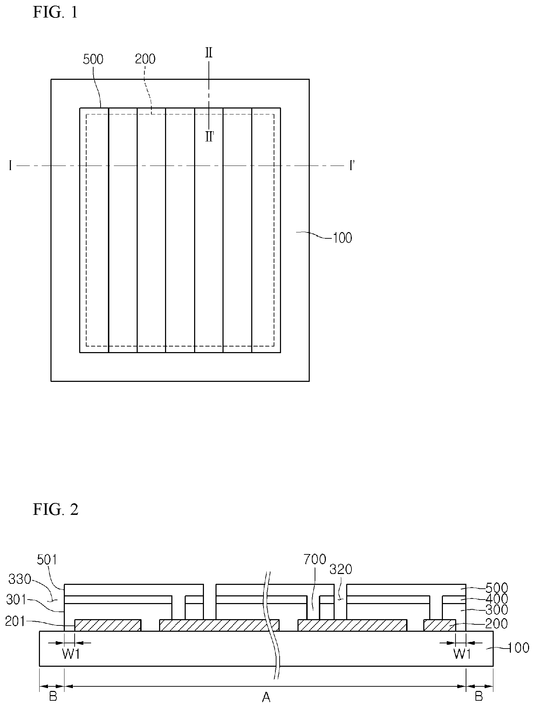

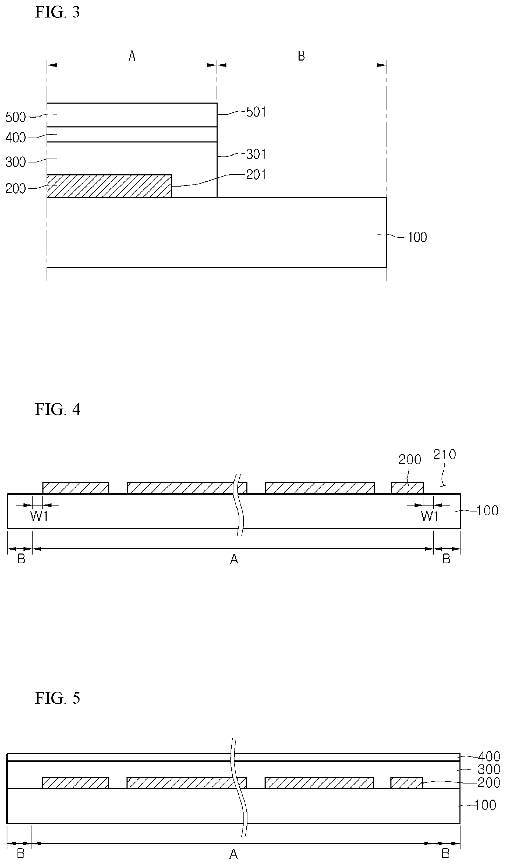

FIG. 1 is a plan view showing a solar cell apparatus according to an example of the disclosure. FIG. 2 is a sectional view taken along line I-I' of FIG. 1. FIG. 3 is a sectional view showing taken along II-II' of FIG. 1.

Referring to FIGS. 1 to 3, the solar cell apparatus includes a support substrate 100, a back electrode layer 200, a light absorbing layer 300, a buffer layer 400, a front electrode layer 500, and a plurality of connection parts 700.

The support substrate 100 has a plate shape, and supports the back electrode layer 200, the light absorbing layer 300, the buffer layer 400, the front electrode layer 500, and the connection parts 700.

The support substrate 100 may include an insulating material. For instance, the support substrate 100 may be a glass substrate, a plastic substrate or a metal substrate. In detail, the support substrate 100 may include a soda lime glass substrate. In addition, the support substrate 100 may be transparent. The support substrate 100 may be rigid or flexible.

The support substrate 100 includes a cell region A and an edge region B. In detail, the support substrate 100 may be divided into the cell region A and the edge region B. In other words, the cell region A and the edge region B are defined in the support substrate 100.

The cell region A is defined at the central portion of the support substrate 100. The cell region A may have a rectangular shape. The cell region A may be provided at the most part of a top surface of the support substrate 100.

The edge region B surrounds the cell region A. The edge region B is extended along an outer peripheral portion of the cell region A. In other words, when viewed in a plan view, the edge region B may have a ring shape.

The back electrode layer 200 is provided on the support substrate 100. The back electrode layer 200 is provided in the cell region A. An outer lateral side 201 of the back electrode layer 200 is extended along an outer portion of the cell region A. In other words, the outer lateral side 201 of the back electrode layer 200 corresponds to the outer portion of the cell region A. In this case, the outer lateral side 201 of the back electrode layer 200 may be provided inward more than the outer portion of the cell region A.

When viewed in a plan view, the back electrode layer 200 may have a rectangular shape. The back electrode layer 200 is a conductive layer. A material constituting the back electrode layer 200 may include metal such as molybdenum (Mo).

In addition, the back electrode layer 200 may include at least two layers. In this case, the layers may include the same metal, or different metals.

The back electrode layer 200 is formed therein with first perforation holes. The first perforation holes are open regions to expose the top surface of the support substrate 100. When viewed in the plan view, the first perforation holes may have a shape to extend in one direction.

Each first perforation hole may have a width in the range of about 80µm to about 200µm.

By the first perforation holes, the back electrode layer 200 is divided into a plurality of back electrodes. In other words, the back electrodes are defined by the first perforation holes.

The back electrodes are spaced apart from each other by the first perforation holes. The back electrodes are arranged in the form of a strip.

In addition, the back electrodes may be arranged in the form of a matrix. In this case, when viewed in a plan view, the first perforation holes may be provided in the form of a lattice.

The light absorbing layer 300 is formed on the back electrode layer 200. The light absorbing layer 300 is provided in the cell region A. An outer lateral side 301 of the light absorbing layer 300 corresponds to the outer portion of the cell region A. In this case, the outer lateral side 301 of the light absorbing layer 300 may match with the boundary between the cell region A and the edge region B. In other words, the edge region B may be defined by the outer lateral side 301 of the light absorbing layer 300.

In addition, the outer lateral sides 301 and 201 of the light absorbing layer 300 and the back electrode layer 200 may be provided on planes different from each other. In more detail, the outer lateral side 301 of the light absorbing layer 300 may be provided outward ore than the outer lateral side 201 of the back electrode layer 200.

Therefore, the outer lateral side 301 of the light absorbing layer 300 may be positioned at a distance of about 1mm to about 10mm from the outer lateral side 201 of the back electrode layer 200. In addition, the light absorbing layer 300 covers the outer lateral side 201 of the back electrode layer 200.

The light absorbing layer 300 covers a region in which the back electrode layer 200 is formed. In other words, a region in which the light absorbing layer 300 is provided is greater than the region in which the back electrode layer 200 is provided. A surface area of the light absorbing layer 300 is greater than a surface area of the back electrode layer 200.

An outer portion of the light absorbing layer 300 surrounds the back electrode layer 200. In other words, the outer portion of the back electrode layer 200 is provided inward more than the outer portion of the light absorbing layer 300. A material constituting the light absorbing layer 300 is filled in the first perforation holes.

The light absorbing layer 300 may include group I-III-VI-based compounds. For example, the light absorbing layer 300 may have a Cu-In-Ga-Se (Cu (In, Ga) Se₂; CIGS)-based crystal structure, a Cu-In-Se-based crystal structure, or a Cu-Ga-Se-based crystal structure.

The energy band gap of the light absorbing layer 300 may be in the range of about I.eV to about 1.8eV.

The buffer layer 400 is provided on the light absorbing layer 300. The buffer layer 400 is provided in the cell region A. The buffer layer 400 has the same plan shape as that of the light absorbing layer 300. The buffer layer 400 includes cadmium sulfide (CdS), and the energy band gap of the buffer layer 400 is in the range of about 2.2eV to about 2.4eV.

The light absorbing layer 300 and the buffer layer 400 are formed therein with second perforation holes 310. The second perforation holes 310 are formed through the light absorbing layer 300. In addition, the second perforation holes 310 are open regions to expose the top surface of the back electrode layer 200.

The second perforation holes 310 are adjacent to the first perforation holes. In other words, when viewed in a plan view, portions of the second perforation holes 310 are formed beside the first perforation holes.

Each second perforation hole 310 has a width in the range of about 80µm to about 200µm.

In addition, the light absorbing layer 300 defines a plurality of light absorbing parts by the second perforation holes 310. In other words, the light absorbing layer 300 is divided into the light absorbing parts by the second perforation holes 310.

The buffer layer 400 is defined as a plurality of buffers by the second perforation holes 310. In other words, the buffer layer 400 is divided into the buffers by the second perforation holes 310.

The front electrode layer 500 is provided on the buffer layer 400. The front electrode layer 500 is provided in the cell region A. The front electrode layer 500 may have a plane shape corresponding to that of the light absorbing layer 300.

An outer lateral side 501 of the front electrode layer 500 may correspond to the outer portion of the cell region A. In other words, the outer lateral side 501 of the front electrode layer 500 may match with the outer portion of the cell region A. The outer lateral side 501 of the front electrode layer 500 may match with the boundary between the cell region A and the edge region B.

The outer lateral sides 501 and 201 of the front electrode layer 500 and the back electrode layer 200 are provided on a different plane. In more detail, the outer lateral side 501 of the front electrode layer 500 may be provided outward more than the outer lateral side 201 of the back electrode layer 200. In this case, the outer lateral side 501 of the front electrode layer 500 and the outer lateral side 301 of the light absorbing layer 300 may be provided on the same plane.

Therefore, a distance W1 between the outer lateral side 501 of the front electrode layer 500 and the outer lateral side 201 of the back electrode layer 200 may be in the range of about 1mm to about 10mm. In addition, the front electrode layer 500 covers the outer lateral side 201 of the back electrode layer 200.

The front electrode layer 500 covers the region in which the back electrode layer 200 is provided. In other words, the region in which the front electrode layer 500 is provided is greater than the region in which the back electrode layer 200 is provided. A surface area of the front electrode layer 500 is greater than a surface area of the back electrode layer 200.

The outer portion of the front electrode layer 500 surrounds the back electrode layer 200. In other words, the outer portion of the back electrode layer 200 is provided inward more than the outer portion of the front electrode layer 500. In addition, the outer portion of the front electrode layer 500 may match with the outer portion of the back electrode layer 200.

The front electrode layer 500 is transparent and includes a conductive layer. The front electrode layer 500 includes a conductive oxide. For example, the front electrode layer 500 may include zinc oxide (ZO), indium tin oxide (ITO), or indium zinc oxide (IZO).

In addition, the oxide may include conductive dopants such as aluminum (Al), alumina (Al2O3), magnesium (Mg), or gallium (Ga). In more detail, the front electrode layer 500 may include Al doped zinc oxide (AZO) or Ga doped zinc oxide (GZO).

The buffer layer 400 and the front electrode layer 500 are formed therein with third perforation holes 320. The third perforation holes 320 are open regions to expose the top surface of the back electrode layer 200. For example, each third perforation holes 320 has a width in the range of 80µm to about 200µm.

The third perforation holes 320 are adjacent to the second perforation holes 310. In more detail, the third perforation holes 320 are provided beside the second perforation holes 310. In other words, when viewed in a plan view, the third perforation holes 320 are provided beside the second perforation holes 310 in parallel.

The front electrode layer 500 is divided into a plurality of front electrodes by the third perforation holes 320. In other words, the front electrodes are defined by the third perforation holes 320.

The front electrodes have shapes corresponding to that of the back electrodes. In other words, the front electrodes are arranged in the form of a strip. In addition, the front electrodes may be provided in the form of a matrix.

In addition, a plurality of cells are defined by the third perforation holes 320. In more detail, the cells are defined by the second and third perforation holes 310 and 320. The solar cell apparatus is partitioned into the cells by the second and third perforation holes 310 and 320.

The connection parts 700 are provided inside the second perforation holes 310. The connection parts 700 are extended downwardly from the front electrode layer 500 to connect to the back electrode layer 200.

Accordingly, the connection parts 700 connect adjacent cells to each other. In other words, the connection parts 700 connect the front electrode and the rear electrode of the adjacent cells to each other.

The connection parts 700 are formed integrally with the front electrode layer 500. In other words, a material constituting the connection parts 700 is the same as a material constituting the front electrode layer 500.

In the solar cell apparatus, the outer lateral sides 201 and 501 of the back electrode layer 200 and the front electrode layer 500 are provided on different planes. Therefore, the distance between the outer lateral side 201 of the back electrode layer 200 and the outer lateral side 501 of the front electrode layer 500 is increased.

Therefore, in the solar cell apparatus, the outer lateral side 201 of the back electrode layer 200 can be prevented from being shorted with the outer lateral side 501 of the front electrode layer 500. In addition, in the solar cell apparatus, leakage current can be prevented from being generated through the outer lateral side 201 of the back electrode layer 200 and the outer lateral side 501 of the front electrode layer 500.

The outer lateral side 201 of the back electrode layer 200 may be covered by the light absorbing layer 300. Therefore, the outer lateral side 201 of the back electrode layer 200 may be effectively insulated by the light absorbing layer 300.

In the solar cell apparatus, short and leakage current can be prevented in the back and front electrode layers 200 and 500. Therefore, electrical characteristics can be improved, and high photoelectric transformation efficiency can be represented.

FIGS. 4 to 9 are sectional views showing a method for fabricating the solar cell apparatus. The above description about the solar cell apparatus will be incorporated in the description about the solar cell apparatus according to the example.

Referring to FIG. 4, the back electrode layer 200 is formed on the support substrate 100 including the cell region A and the edge region B.

The cell region A is a region in which a plurality of solar cells are arranged, and the edge region B is a region without the solar cells. The support substrate 100 may include a glass substrate. In addition, the support substrate 100 may include a ceramic substrate such as alumina, a stainless steel substrate, a titanium substrate, or a polymer substrate. The glass substrate may include soda lime glass, and the polymer substrate may include polyimide. In addition, the support substrate 100 may be rigid or flexible.

In order to form the back electrode layer 200, metal such as Mo is deposited on the support substrate 100. Thereafter, the back electrode layer 200 is patterned through a photo-lithography process. In addition, the back electrode layer 200 is a patterned metallic layer.

The first perforation holes are formed through the back electrode layer 200 through the patterning process. In addition, through the patterning process, the outer portion of the back electrode layer 200 is removed, thereby forming a first edge pattern 210. The first edge pattern 210 is formed inward more than the outer portion of the cell region A. Therefore, the outer portion of the back electrode layer 200 is provided inward more than the outer portion of the cell region A. In other words, the back electrode layer 200 is not provided in the edge region B.

A portion of the cell region A and the entire portion of the edge region B can be exposed by the first edge pattern 210.

The back electrode layer 200 may include a conductor such as metal. For example, the back electrode layer 200 may be formed through a sputtering process by using a Mo target. This is because the Mo has high electrical conductivity, allows the back electrode layer 200 to make ohmic contact with the light absorbing layer 300, and represents high-temperature stability under a Se atmosphere.

In addition, although not shown in the drawings, the back electrode layer 200 may include at least one layer. When the back electrode layer 200 includes a plurality of layers, the layers of the back electrode layer 200 may include materials different from each other.

As shown in FIG. 5, the light absorbing layer 300 and the buffer layer 400 are formed on the back electrode layer 200. The light absorbing layer 300 and the buffer layer 400 may be formed in the edge region B of the support substrate 100.

The light absorbing layer 300 may cover both of the back electrode layer 200 and the support substrate 100. In this case, the light absorbing layer 300 may cover the whole outer lateral side 201 of the back electrode layer 200.

The light absorbing layer 300 includes a group -III-Vl-based semiconductor compound. In other words, the light absorbing layer 300 includes a group -III -VI-based semiconductor compound which is opaque. In more detail, the light absorbing layer 300 may include a Cu-In-Ga-Se (Cu (In, Ga) Se₂, CIGS)-based compound.

In addition, the light absorbing layer 300 may include a Cu-In-Se (CuInSe₂ CIS)-based compounds or Cu-Ga-Se (CuGaSe₂, CGS)-based compounds.

In order to form the light absorbing layer 300, a CIG-based metallic precursor layer is formed on the back electrode layer 200 by using a copper target, an indium target, and a gallium target.

Thereafter, the metallic precursor layer reacts with the Se through a selenization process, thereby forming the CIGS-based light absorbing layer 300.

In addition, during the process of forming the metallic precursor layer and the selenization process, an alkali component constituting the support substrate 100 is spread into the metallic precursor and the light absorbing layer 300 through the back electrode layer 200.

The alkali compound can enhance the size of the grains of the light absorbing layer 300, and improve crystalline.

In addition, the light absorbing layer 300 may be formed through a co-evaporation scheme for Cu, In, Ga, and Se.

The light absorbing layer 300 converts light received therein into electrical energy. The light absorbing layer 300 generates photoelectro-motive force due to the photoelectric effect.

The buffer layer 400 includes at least one layer. The buffer layer 400 may be formed on the support substrate 100 having the light absorbing layer 300 by using one of CdS, ITO, ZnO, and i-ZnO or the stack structure thereof.

In this case, the buffer layer 400 includes an N type semiconductor layer, and the light absorbing layer 300 includes a P type semiconductor layer. Accordingly, the light absorbing layer 300 and the buffer layer 400 form a PN junction.

The buffer layer 400 is interposed between the light absorbing layer 300 and the front electrode layer to be formed later.

In other words, since the light absorbing layer 300 make a great difference in a lattice constant and energy band gap from the front electrode layer, the buffer layer 400 having intermediate energy band gap between energy band gaps of the light absorbing layer 300 and the front electrode layer is interposed between the light absorbing layer 300 and the front electrode layer, so that superior bonding can be formed.

Although one buffer layer 400 is formed on the light absorbing layer 300, the embodiment is not limited thereto. In other words, the buffer layer 400 may include a plurality of layers.

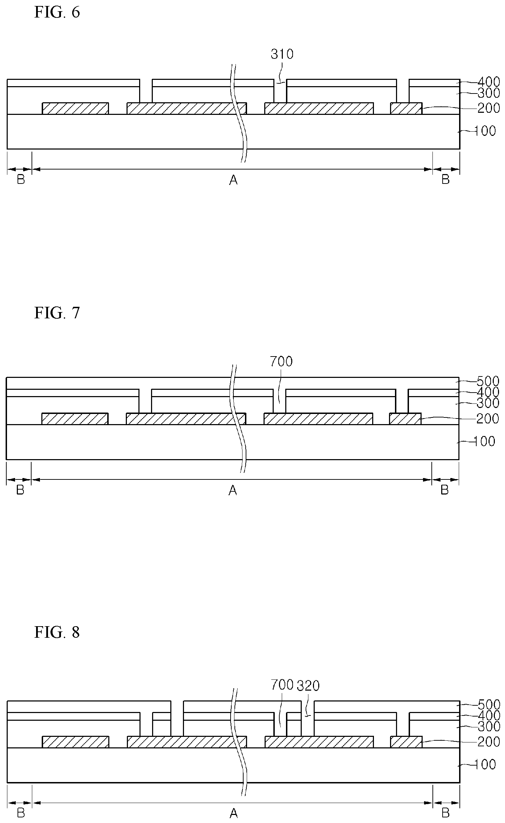

Therefore, as shown in FIG. 6, the second perforation holes 310 are formed through the light absorbing layer 300 and the buffer layer 400.

The second perforation holes 310 may be formed through a mechanical scheme or a process based on a laser, and exposes a portion of the back electrode layer 200.

In addition, as shown in FIG. 7, the front electrode layer 500 and the connection wires 700 are formed on the buffer layer 400 by using a transparent conductive material.

When the transparent conductive material is stacked on the buffer layer 400, the transparent conductive material is inserted into the second perforation holes 310 to form the connection wires 700.

The back electrode layer 200 is electrically connected to the front electrode layer 500 by the connection wires 700.

The front electrode layer 500 is formed on the support substrate 100 through a sputtering process by using A1 doped zinc oxide.

The front electrode layer 500 serves as a window layer forming the PN junction with the light absorbing layer 300, and a transparent electrode at the front side of a solar cell. Accordingly, the front electrode layer 500 includes zinc oxide (ZnO) representing high light transmittance and high electrical conductivity.

In this case, the electrode may represent low resistance by doping the ZnO with Al.

A ZnO thin film which is the front electrode layer 500 may be formed through an RF sputtering scheme based on a ZnO target, a reactive sputtering scheme using a Zn target, and a metal organic chemical vapor deposition scheme.

In addition, the front electrode layer 500 may have a dual structure formed by depositing an ITO thin film representing superior electrical and optical characteristics on the ZnO thin film.

As shown in FIG. 8, the third perforation holes 320 are formed through the light absorbing layer 300, the buffer layer 400, and the front electrode layer 500.

The third perforation holes 320 are formed by performing a process based on a mechanical scheme or a laser, and a portion of the back electrode layer 200 is exposed.

The light absorbing layer 300, the buffer layer 400, and the front electrode layer 500 may be divided by the third perforation holes 320. In other words, each cell may be defined by the third perforation holes 320.

The front electrode layer 500, the buffer layer 400, and the light absorbing layer 300 may be patterned in the form of a strip or the form of a matrix by the third perforation holes 320. The example is not limited thereto, but the third perforation holes 320 may have various shapes.

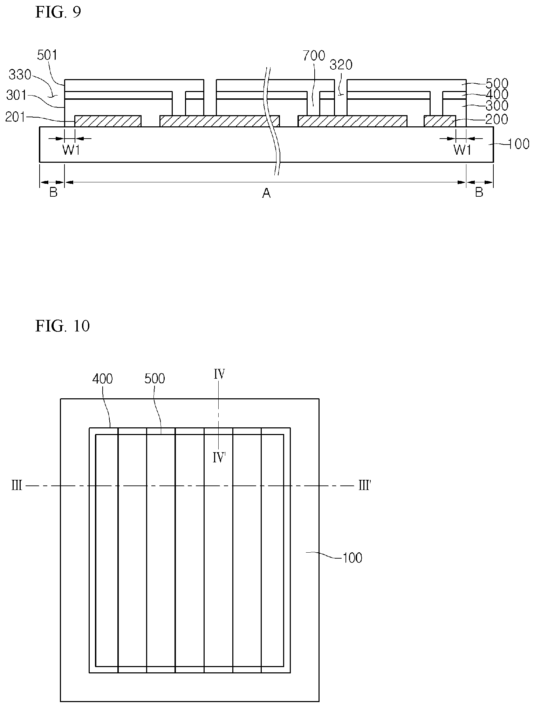

Referring to FIG. 9, the outer portions of the light absorbing layer 300, the buffer layer 400, and the front electrode layer 500 are simultaneously removed corresponding to the edge region B, thereby forming the second edge pattern 330.

The second edge pattern 330 is formed by removing the stack structure of the light absorbing layer 300, the buffer layer 400, and the front electrode layer 500 of the edge region B by irradiating a laser beam to the edge region B or by performing a mechanical process with respect to the edge region B.

In other words, the edge region B is defined through a process of forming the second edge pattern 330. Accordingly, the outer lateral sides of the light absorbing layer 300 and the buffer layer 400, and the outer lateral side 501 of the front electrode layer 500 may match with the outer portion of the cell region A.

In addition, the outer portions of the light absorbing layer 300, the buffer layer 400, and the front electrode layer 500 are simultaneously removed, thereby forming the second edge pattern 330. Therefore, the outer lateral side 301 of the light absorbing layer 300, the outer lateral side of the buffer layer 400, and the outer lateral side 501 of the front electrode layer are provided on the same plane.

In addition, the edge region B of the support substrate 100 may be exposed to the outside, and the light absorbing layer 300 may directly make contact with the support substrate 100 at the end portion of the cell region A.

The outer lateral side 201 of the back electrode layer 200 is spaced apart from the outer lateral side 501 of the front electrode layer 500 by a predetermined distance. The distance between the outer lateral side 201 of the back electrode layer 200 and the outer lateral side 501 of the front electrode layer 500 may be in the range of about 1mm to about 10mm. The outer lateral side 201 of the back electrode 200 is covered by the light absorbing layer 300. In more detail, the light absorbing layer 300 may cover the whole outer lateral side 201 of the back electrode layer 200.

Therefore, the outer lateral side 201 of the back electrode layer 200 can be prevented from being shorted with the outer lateral side 501 of the front electrode layer 500. In other words, when the second edge pattern 330 is formed, although the front electrode layer 500 flows down by the laser beam, the front electrode layer 500 is not shorted with the back electrode layer 200.

Therefore, when an edge deletion process is performed in order to form the second edge pattern 330, the front electrode layer 500 can be prevented from being shorted with the back electrode layer 200, thereby preventing leakage current in the solar cell apparatus.

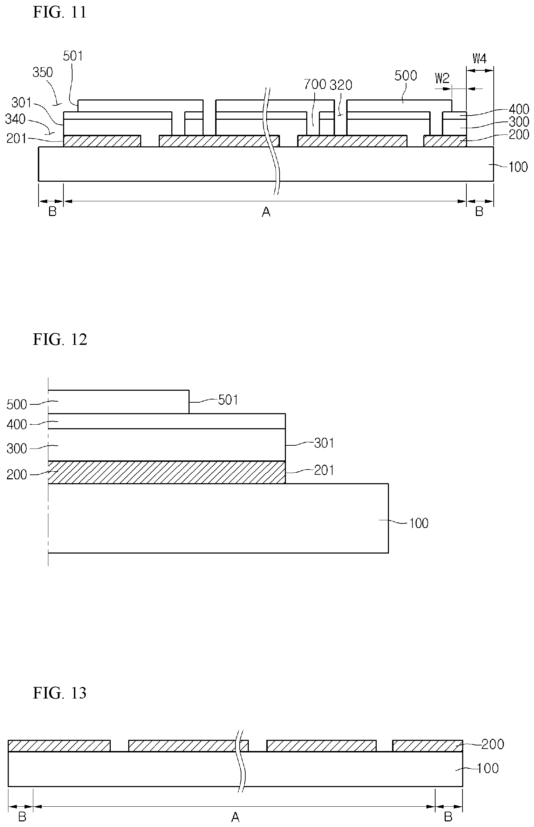

FIG. 10 is a plan view showing a solar cell apparatus according to the invention. FIG. 11 is a sectional view taken along line III-III' of FIG. 10. FIG. 12 is a sectional view showing taken along line IV-IV' of FIG. 10. The solar cell apparatus will be described by making reference to the above description about the solar cell apparatus according to the example discussed above, and a back electrode layer and a front electrode layer will be additionally described. In other words, the above description will be incorporated in the description about the embodiment of the invention except for the modifications.

Referring to FIGS. 10 to 12, the outer lateral side 201 of the back electrode layer 200 and the outer lateral side 501 of the front electrode layer 500 are provided on different planes. For example, the outer lateral side 201 of the back electrode layer 200 is provided outward more than the outer lateral side 501 of the front electrode layer 500.

The outer lateral side 201 of the back electrode layer 200 corresponds to the outer portion of the cell region A. In other words, the outer lateral side 201 of the back electrode layer 200 may match with the outer portion of the cell region A. In addition, the outer lateral side 501 of the front electrode layer 500 corresponds to the outer portion of the cell region A. In other words, the outer lateral side 501 of the front electrode layer 500 is extended along the outer region of the cell region A, and may be provided inward more than the outer portion of the cell region A.

In addition, the outer lateral side 301 of the light absorbing layer 300 is provided outward more than the outer lateral side 501 of the front electrode layer 500. In this case, the outer lateral side 301 of the light absorbing layer 300 and the outer lateral side 201 of the back electrode layer 200 may be provided on the same plane.

A third edge pattern 340 is formed at the outer portions of the back electrode layer 200 and the light absorbing layer 300, and a fourth edge pattern 350 is formed at the outer portion of the front electrode layer 500. In this case, a width W3 of the third edge pattern 340 is smaller than a width W4 of the fourth edge pattern 350. In addition, by the fourth edge pattern 350, a portion of the top surface of the light absorbing layer 300 may be exposed.

In addition, the surface area of the front electrode layer 500 is smaller than that of the back electrode layer 200. In addition, a distance W2 between the outer lateral side 501 of the front electrode layer 500 and the outer lateral side 201 of the back electrode layer 200 may be in the range of about 1mm to about 10mm.

Since the outer lateral side 201 of the back electrode layer 200 and the outer lateral side 501 of the front electrode layer 500 are provided on planes different from each other, the outer lateral side 201 of the back electrode layer 200 can be prevented from being shorted with the outer lateral side 501 of the front electrode layer 500.

In other words, since the front electrode layer 500 is formed inward more than the outer portion of the cell region A, although the edge deletion process is performed, leakage current between the front electrode layer 500 and the back electrode layer 200 can be prevented.

FIGS. 13 to 18 are sectional views showing a method for manufacturing a solar cell apparatus according to the invention. The above description about the example mentioned above and the above description about the solar cell apparatus according to the invention will be incorporated in the description about the method for manufacturing the solar cell apparatus according to the embodiment of the invention except for the modifications.

Referring to FIG. 13, the back electrode layer 200 is formed on the support substrate 100 including the cell region A and the edge region B. In this case, the back electrode layer 200 is formed on the whole surface of the support substrate 100. In other words, the back electrode layer 200 may be formed on the cell region A and the edge region B. The back electrode layer 200 may be formed therein with the first perforation holes.

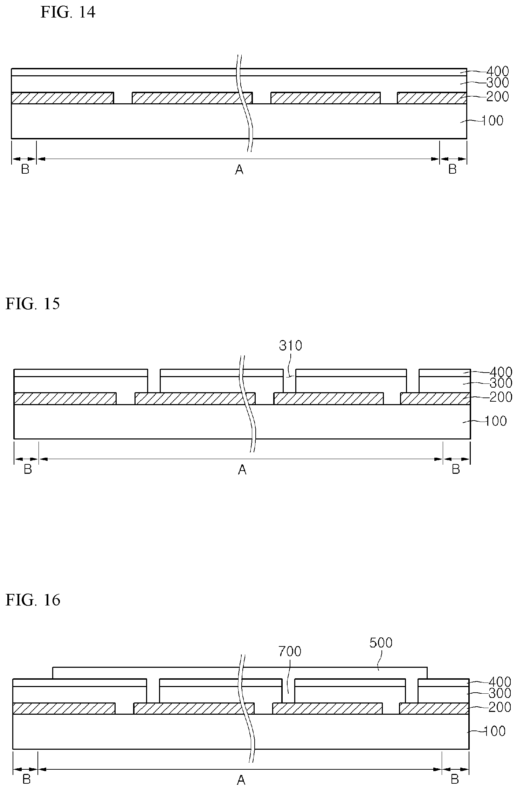

Referring to FIG. 14, the light absorbing layer 300 and the buffer layer 400 are formed on the support substrate 100 having the back electrode layer 200. The light absorbing layer 300 and the buffer layer 400 may be formed on the whole surface of the support substrate 100. In other words, the light absorbing layer 300 and the buffer layer 400 may be formed on the whole top surface of the back electrode layer 200.

Referring to FIG. 15, the second perforation holes 310 are formed through the light absorbing layer 300 and the buffer layer 400. The second perforation holes 310 may be formed through a process using a mechanical scheme or a laser, and exposes a portion of the back electrode layer 200.

Referring to FIG. 16, a transparent conductive material is deposited on the buffer layer 400, thereby forming the front electrode layer 500 and the connection wires 700. When the transparent conductive material is deposited on the buffer layer 400, the transparent conductive material may be inserted into the second perforation holes 310 to form the connection wires 700.

The back electrode layer 200 is electrically connected to the front electrode layer 500 by the connection wires 700.

The front electrode layer 500 may be formed only in the cell region A, and the buffer layer 400 may be exposed. In other words, the buffer layer 400 formed in the edge region B may be exposed, and the buffer layer 400 formed at the end portion of the cell region A may be exposed also.

In this case, the front electrode layer 500 may be formed only in the cell region A except for the edge region B after providing a mask (not shown) on the edge region B. Therefore, the fourth edge pattern 350 is formed on the outer portion of the front electrode layer 500.

In addition, the embodiment is not limited thereto, but the fourth edge pattern 350 may be formed through a patterning process such as an etching process or a mechanical scribing process after forming the front electrode layer 500 on the whole surface of the support substrate 100.

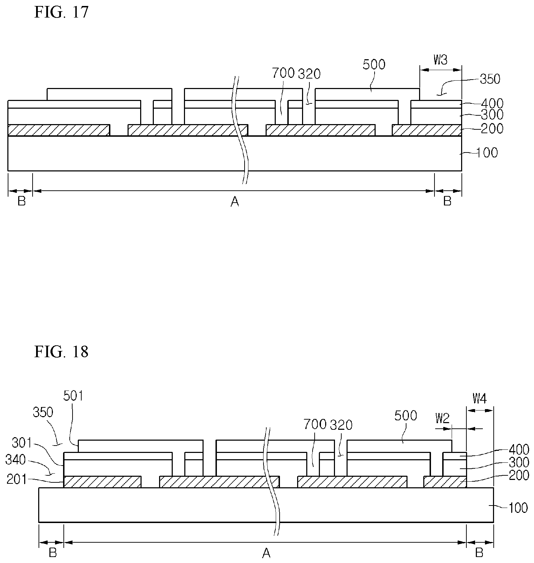

Referring to FIG. 17, the third perforation holes 320 are formed through the light absorbing layer 300, the buffer layer 400, and the front electrode layer 500.

The third perforation holes 320 may be formed through a process using a mechanical scheme or a laser, and exposes the portion of the back electrode layer 200.

Thereafter, as shown in FIG. 18, the third edge pattern 340 is formed by removing the stack structure of the back electrode layer 200, the light absorbing layer 300, and the buffer layer 400 formed on the edge region B.

The third edge pattern 340 is formed by removing the stack structure of the back electrode layer 200, the light absorbing layer 300, and the buffer layer 400 of the edge region B by irradiating a laser beam into the edge region B or by performing a mechanical process for the edge region B.

The third edge pattern 340 has the width smaller than that of the fourth edge pattern 350. The third edge pattern 340 and the fourth edge pattern 350 may have a rectangular ring shape when viewed in a plan view.

The distance W2 between the outer lateral side 501 of the front electrode layer 500 and the outer lateral side 201 of the back electrode layer 200 may be in the range of about 1mm to about 10mm.

Since the outer lateral side 201 of the back electrode layer 200 and the outer lateral side 501 of the front electrode layer 500 are provided on planes different from each other, the outer lateral side 201 of the back electrode layer 200 can be prevented from being shorted with the outer lateral side 501 of the front electrode layer 500.

Therefore, when the third edge pattern 340 is formed, since the outer lateral side 501 of the front electrode layer 500 is spaced apart from the outer portion of the edge region B, the front electrode layer 500 does not flow down by a laser beam.

Therefore, when the edge deletion process to form the third edge pattern is performed, the short between the front electrode layer 500 and the rear electrode layer 200 can be prevented, and the leakage current of the solar cell apparatus can be prevented.

Although samples have been described with reference to a number of illustrations thereof, it should be understood that numerous other modifications and examples can be devised by those skilled in the art that will fall within the scope of the principles of this disclosure. More particularly, various variations and modifications are possible in the component parts and/or arrangements of the subject combination arrangement within the scope of the disclosure, the drawings within the scope of the appended claims. In addition to variations and modifications in the component parts and/or arrangements, alternative uses will also be apparent to those skilled in the art.

### [Industrial Applicability]

The solar cell apparatus according to the embodiment is applicable to a solar power generation field.

## Claims

1. A solar cell apparatus comprising:
a substrate (100) including a cell region (A) having an outer portion and an edge region (B) surrounding the cell region (A);
a back electrode layer (200) on the substrate (100), said back electrode layer (200) having an outer lateral side (201);
a light absorbing layer (300) on the back electrode layer (200), said light absorbing layer (300) having an outer lateral side (301); and
a front electrode layer (500) on the light absorbing layer (300), said front electrode layer (500) having an outer lateral side (501),
wherein the outer lateral side (201) of the back electrode layer (200) corresponds to a boundary between the cell region (A) and the edge region (B),
wherein the outer lateral side (201) of the back electrode layer (200) is aligned on a plane different from a plane of the outer lateral side (501) of the front electrode layer (500),
wherein the outer lateral side (201) of the back electrode layer (200) is provided outward more than the outer lateral side (501) of the front electrode layer (500),
wherein the outer lateral side (301) of the light absorbing layer (300) is extended outward more than the outer lateral side (501) of the front electrode layer (500),
wherein the outer lateral side (201) of the back electrode layer (200) is aligned on a same plan with the outer lateral side (301) of the light absorbing layer (300) .

2. The solar cell apparatus of claim 1, wherein a distance between the outer lateral sides (201,501) of the back and front electrode layers (200,500) is in a range of 1mm to 10mm.

3. The solar cell apparatus of claim 1, wherein the back electrode layer (200), the light absorbing layer (300) and the front electrode layer (500) are not disposed on the edge region (B), the edge region (B) forming thus an open region to expose a top surface of the substrate (100).

4. The solar cell apparatus of claim 1, wherein, when viewed in a plan view, the edge region (B) has a ring shape.

5. The solar cell apparatus of claim 1, wherein the surface area of the front electrode layer (500) is smaller than that of the back electrode layer (200).

6. The solar cell apparatus of claim 1,
wherein the back electrode layer (200) is divided into a plurality of back electrodes;
wherein the front electrode layer (500) is divided into a plurality of front electrodes, and
wherein the back electrode layer (200) is formed therein with a plurality of first perforation holes extending in a first direction,
the light absorbing layer (300) is formed therein with a plurality of second perforation holes adjacent to the first perforation holes, respectively, and
the front electrode layer (500) is formed therein with a plurality of third perforation holes adjacent to the second perforation holes.

7. The solar cell apparatus of claim 1, wherein the solar cell apparatus includes a buffer layer (400) disposed between the light absorbing layer (300) and the front electrode (500), wherein an outer lateral side of the buffer layer (400) is aligned on a same plane with the outer lateral side (201) of the back electrode layer (200) and the outer lateral side (301) of the light absorbing layer (300).

8. A method for manufacturing a solar cell apparatus according to claim 1, the method comprising:
forming a back electrode layer (200) on a substrate (100) including a cell region (A) having an outer portion and an edge region (B) surrounding the cell region (A) said back electrode layer (200) having an outer lateral side (201);
forming a light absorbing layer (300) on the back electrode layer (200); said light absorbing layer (300) having an outer lateral side (301), and
forming a front electrode layer (500) on the light absorbing layer (300), said front electrode layer (500) having an outer lateral side (501),
wherein the outer lateral side (201) of the back electrode layer (201) corresponds to a boundary between the cell region (A) and the edge region (B),
wherein the outer lateral side (201) of the back electrode layer (200) is aligned on a plane different from a plane of the outer lateral side (501) of the front electrode layer (500),
wherein the outer lateral side (201) of the back electrode layer (200) is provided outward more than the outer lateral side (501) of the front electrode layer (200),
wherein the outer lateral side (301) of the light absorbing layer (300) is extended outward more than the outer lateral side (501) of the front electrode layer (500),
wherein the outer lateral side (201) of the back electrode layer (200) is aligned on a same plan with the outer lateral side (301) of the light absorbing layer (300) .

## Revendications

1. Appareil à cellules solaires, comprenant :
un substrat (100) incluant une région de cellule (A) ayant une portion extérieure et une région de bord (B) entourant la région de cellule (A) ;
une couche d'électrodes arrière (200) sur le substrat (100), ladite couche d'électrodes arrière (200) ayant un côté latéral extérieur (201) ;
une couche d'absorption de lumière (300) sur la couche d'électrodes arrière (200), ladite couche d'absorption de lumière (300) ayant un côté latéral extérieur (301) ; et
une couche d'électrodes avant (500) sur la couche d'absorption de lumière (300), ladite couche d'électrodes avant (500) ayant un côté latéral extérieur (501),
dans lequel le côté latéral extérieur (201) de la couche d'électrodes arrière (200) correspond à une frontière entre la région de cellule (A) et la région de bord (B),
dans lequel le côté latéral extérieur (201) de la couche d'électrodes arrière (200) est aligné sur un plan différent d'un plan du côté latéral extérieur (501) de la couche d'électrodes avant (500),
dans lequel le côté latéral extérieur (201) de la couche d'électrodes arrière (200) est prévu vers l'extérieur davantage que le côté latéral extérieur (501) de la couche d'électrodes avant (500),
dans lequel le côté latéral extérieur (301) de la couche d'absorption de lumière (300) s'étend vers l'extérieur davantage que le côté latéral extérieur (501) de la couche d'électrodes avant (500),
dans lequel le côté latéral extérieur (201) de la couche d'électrodes arrière (200) est aligné sur un même plan avec le côté latéral extérieur (301) de la couche d'absorption de lumière (300).

2. Appareil à cellules solaires selon la revendication 1, dans lequel une distance entre les côtés latéraux extérieurs (201, 501) des couches d'électrodes arrière et avant (200, 500) est dans une plage de 1 mm à 10 mm.

3. Appareil à cellules solaires selon la revendication 1, dans lequel la couche d'électrodes arrière (200), la couche d'absorption de lumière (300) et la couche d'électrodes avant (500) ne sont pas disposées sur la région de bord (B), la région de bord (B) formant ainsi une région ouverte pour exposer une surface supérieure du substrat (100).

4. Appareil à cellules solaires selon la revendication 1, dans lequel, en vue en plan, la région de bord (B) est de forme annulaire.

5. Appareil à cellules solaires selon la revendication 1, dans lequel la superficie de la couche d'électrodes avant (500) est inférieure à celle de la couche d'électrodes arrière (200).

6. Appareil à cellules solaires selon la revendication 1,
dans lequel la couche d'électrodes arrière (200) est divisée en une pluralité d'électrodes arrière ;
dans lequel la couche d'électrodes avant (500) est divisée en une pluralité d'électrodes avant, et
dans lequel la couche d'électrodes arrière (200) est formée à l'intérieur de celle-ci avec une pluralité de premiers trous de perforation s'étendant dans un premier sens,
la couche d'absorption de lumière (300) est formée à l'intérieur de celle-ci avec une pluralité de deuxièmes trous de perforation adjacents respectivement aux premiers trous de perforation, et
la couche d'électrodes avant (500) est formée à l'intérieur de celle-ci avec une pluralité de troisièmes trous de perforation adjacents aux deuxièmes trous de perforation.

7. Appareil à cellules solaires selon la revendication 1, dans lequel l'appareil à cellules solaires inclut une couche tampon (400) disposée entre la couche d'absorption de lumière (300) et la couche d'électrodes avant (500), dans lequel un côté latéral extérieur de la couche tampon (400) est aligné sur un même plan avec le côté latéral extérieur (201) de la couche d'électrodes arrière (200) et le côté latéral extérieur (301) de la couche d'absorption de lumière (300) .

8. Procédé de fabrication d'un appareil à cellules solaires selon la revendication 1, le procédé comprenant :
la formation d'une couche d'électrodes arrière (200) sur un substrat (100) incluant une région de cellule (A) ayant une portion extérieure et une région de bord (B) entourant la région de cellule (A), ladite couche d'électrodes arrière (200) ayant un côté latéral extérieur (201) ;
la formation d'une couche d'absorption de lumière (300) sur la couche d'électrodes arrière (200), ladite couche d'absorption de lumière (300) ayant un côté latéral extérieur (301) ; et
la formation d'une couche d'électrodes avant (500) sur la couche d'absorption de lumière (300), ladite couche d'électrodes avant (500) ayant un côté latéral extérieur (501),
dans lequel le côté latéral extérieur (201) de la couche d'électrodes arrière (201) correspond à une frontière entre la région de cellule (A) et la région de bord (B),
dans lequel le côté latéral extérieur (201) de la couche d'électrodes arrière (200) est aligné sur un plan différent d'un plan du côté latéral extérieur (501) de la couche d'électrodes avant (500),
dans lequel le côté latéral extérieur (201) de la couche d'électrodes arrière (200) est prévu vers l'extérieur davantage que le côté latéral extérieur (501) de la couche d'électrodes avant (200),
dans lequel le côté latéral extérieur (301) de la couche d'absorption de lumière (300) s'étend vers l'extérieur davantage que le côté latéral extérieur (501) de la couche d'électrodes avant (500),
dans lequel le côté latéral extérieur (201) de la couche d'électrodes arrière (200) est aligné sur un même plan avec le côté latéral extérieur (301) de la couche d'absorption de lumière (300).

## Patentansprüche

1. Solarzellenvorrichtung, umfassend:
ein Substrat (100), das einen Zellbereich (A) einschließt, der einen äußeren Abschnitt und einen Randbereich (B) aufweist, welcher den Zellbereich (A) umgibt;
eine Rückelektrodenschicht (200) auf dem Substrat (100), wobei die Rückelektrodenschicht (200) eine seitliche Außenseite (201) aufweist;
eine lichtabsorbierende Schicht (300) auf der Rückelektrodenschicht (200), wobei die lichtabsorbierende Schicht (300) eine seitliche Außenseite (301) aufweist; und
eine Frontelektrodenschicht (500) auf der lichtabsorbierenden Schicht (300), wobei die Frontelektrodenschicht (500) eine seitliche Außenseite (501) aufweist,
wobei die seitliche Außenseite (201) der Rückelektrodenschicht (200) einer Grenze zwischen dem Zellbereich (A) und dem Randbereich (B) entspricht,
wobei die seitliche Außenseite (201) der Rückelektrodenschicht (200) auf einer Ebene ausgerichtet ist, die sich von einer Ebene der seitlichen Außenseite (501) der Frontelektrodenschicht (500) unterscheidet,
wobei die seitliche Außenseite (201) der Rückelektrodenschicht (200) weiter nach außen bereitgestellt ist als die seitliche Außenseite (501) der Frontelektrodenschicht (500),
wobei sich die seitliche Außenseite (301) der lichtabsorbierenden Schicht (300) weiter nach außen erstreckt als die seitliche Außenseite (501) der Frontelektrodenschicht (500),
wobei die seitliche Außenseite (201) der Rückelektrodenschicht (200) mit der seitlichen Außenseite (301) der lichtabsorbierenden Schicht (300) auf ein und derselben Ebene ausgerichtet ist.

2. Solarzellenvorrichtung nach Anspruch 1, wobei ein Abstand zwischen den seitlichen Außenseiten (201, 501) der Rück- und Frontelektrodenschicht (200, 500) in einem Bereich von 1 mm bis 10 mm liegt.

3. Solarzellenvorrichtung nach Anspruch 1, wobei die Rückelektrodenschicht (200), die lichtabsorbierende Schicht (300) und die Frontelektrodenschicht (500) nicht auf dem Randbereich (B) angeordnet sind, wodurch der Randbereich (B) einen offenen Bereich bildet, um eine obere Fläche des Substrats (100) freizulegen.

4. Solarzellenvorrichtung nach Anspruch 1, wobei der Randbereich (B) in einer Draufsicht betrachtet eine Ringform aufweist.

5. Solarzellenvorrichtung nach Anspruch 1, wobei der Flächeninhalt der Frontelektrodenschicht (500) kleiner ist als jener der Rückelektrodenschicht (200).

6. Solarzellenvorrichtung nach Anspruch 1,
wobei die Rückelektrodenschicht (200) in eine Vielzahl von Rückelektroden unterteilt ist;
wobei die Frontelektrodenschicht (500) in eine Vielzahl von Frontelektroden unterteilt ist, und
wobei die Rückelektrodenschicht (200) mit einer Vielzahl von ersten Perforationslöchern in derselben ausgebildet ist, die sich in einer ersten Richtung erstrecken,
die lichtabsorbierende Schicht (300) mit einer Vielzahl von zweiten Perforationslöchern in derselben ausgebildet ist, die jeweils an die ersten Perforationslöcher angrenzen, und
die Frontelektrodenschicht (500) mit einer Vielzahl von dritten Perforationslöchern in derselben ausgebildet ist, die an die zweiten Perforationslöcher angrenzen.

7. Solarzellenvorrichtung nach Anspruch 1, wobei die Solarzellenvorrichtung eine Pufferschicht (400) einschließt, die zwischen der lichtabsorbierenden Schicht (300) und der Frontelektrode (500) angeordnet ist, wobei eine seitliche Außenseite der Pufferschicht (400) mit der seitlichen Außenseite (201) der Rückelektrodenschicht (200) und der seitlichen Außenseite (301) der lichtabsorbierenden Schicht (300) auf ein und derselben Ebene ausgerichtet ist.

8. Verfahren zur Herstellung einer Solarzellenvorrichtung nach Anspruch 1, wobei das Verfahren umfasst:
Bilden einer Rückelektrodenschicht (200) auf einem Substrat (100), das einen Zellbereich (A) einschließt, der einen äußeren Abschnitt und einen Randbereich (B) aufweist, welcher den Zellbereich (A) umgibt, wobei die Rückelektrodenschicht (200) eine seitliche Außenseite (201) aufweist;
Bilden einer lichtabsorbierenden Schicht (300) auf der Rückelektrodenschicht (200), wobei die lichtabsorbierende Schicht (300) eine seitliche Außenseite (301) aufweist, und
Bilden einer Frontelektrodenschicht (500) auf der lichtabsorbierenden Schicht (300), wobei die Frontelektrodenschicht (500) eine seitliche Außenseite (501) aufweist,
wobei die seitliche Außenseite (201) der Rückelektrodenschicht (201) einer Grenze zwischen dem Zellbereich (A) und dem Randbereich (B) entspricht,
wobei die seitliche Außenseite (201) der Rückelektrodenschicht (200) auf einer Ebene ausgerichtet ist, die sich von einer Ebene der seitlichen Außenseite (501) der Frontelektrodenschicht (500) unterscheidet,
wobei die seitliche Außenseite (201) der Rückelektrodenschicht (200) weiter nach außen bereitgestellt ist als die seitliche Außenseite (501) der Frontelektrodenschicht (200),
wobei sich die seitliche Außenseite (301) der lichtabsorbierenden Schicht (300) weiter nach außen erstreckt als die seitliche Außenseite (501) der Frontelektrodenschicht (500),
wobei die seitliche Außenseite (201) der Rückelektrodenschicht (200) mit der seitlichen Außenseite (301) der lichtabsorbierenden Schicht (300) auf ein und derselben Ebene ausgerichtet ist.
